# FASCICULE DE BREVET EUROPEEN

(11) **EP 3 130 010 B1**
(45) Date de publication et mention de la délivrance du brevet: **18.04.2018**
(21) Numéro de dépôt: 15718527.3
(22) Date de dépôt: 27.03.2015
(51) Int. Cl.: H01L 33/00, H01L 33/20, H01L 33/18, H01L 33/08

(54) **DISPOSITIF OPTOELECTRONIQUE A DIODES ELECTROLUMINESCENTES ET A DIAGRAMME D'EMISSION AMELIORE**
OPTOELEKTRONISCHE VORRICHTUNG MIT LEUCHTDIODEN UND MIT VERBESSERTEM EMISSION DIAGRAMM
OPTOELECTRONIC DEVICE WITH IMPROVED EMISSION DIAGRAM COMPRISING LIGHT EMITTING DIODES

(30) Priorité: 09.04.2014 FR 1453148
(43) Date de publication de la demande: 15.02.2017
(73) Titulaire: Commissariat à l'Energie Atomique et aux Energies Alternatives, 75015 Paris (FR); Aledia, 38040 Grenoble (FR)
(72) Inventeur: GASSE, Adrien, F-38180 Seyssins (FR); ANDRE, Bernard, F-38950 Quaix en Chartreuse (FR); BONO, Hubert, F-38000 Grenoble (FR); HUGON, Xavier, F-38470 Teche (FR)
(74) Mandataire: Thibon, Laurent
(86) Numéro de dépôt international: PCT/FR2015/050810
(87) Numéro de publication internationale: WO 2015/155437

(56) Documents cités:
- EP-A2- 1 847 759
- EP-A2- 2 337 099
- WO-A1-2013/080174
- CN-U- 203 038 972
- US-A1- 2007 195 524

## Description

### Domaine

La présente invention concerne de façon générale les dispositifs optoélectroniques à base de matériaux semiconducteurs et leurs procédés de fabrication. La présente invention concerne plus particulièrement les dispositifs optoélectroniques comprenant des diodes électroluminescentes.

### Exposé de l'art antérieur

Le diagramme d'émission, également appelé diagramme de rayonnement, d'une diode électroluminescente représente la répartition angulaire de l'intensité relative du rayonnement lumineux émis par la diode électroluminescente. Le diagramme d'émission d'une diode électroluminescente est généralement imposé par la structure de la diode électroluminescente.

Il est connu de réaliser une diode électroluminescente comprenant un empilement de couches formées sur un support plan. L'intensité relative du diagramme d'émission d'une telle diode électroluminescente est généralement maximale selon une direction de référence qui correspond à la direction perpendiculaire à la face du support sur laquelle est formée la diode électroluminescente et diminue au fur et à mesure que la direction d'émission est inclinée par rapport à la direction de référence.

Le dispositif optoélectronique à diode électroluminescente peut alors comprendre des systèmes optiques secondaires, notamment des lentilles ou autres systèmes optiques, pour modifier le diagramme d'émission de la diode électroluminescente. En effet, pour certaines applications, il peut être souhaitable que l'intensité relative du diagramme d'émission soit sensiblement la même quelle que soit la direction d'émission. Pour d'autres applications, il peut être souhaitable que l'intensité relative du diagramme d'émission diminue fortement dès que la direction d'émission est inclinée par rapport à la direction de référence.

Un inconvénient des dispositifs optoélectroniques existants est que les systèmes optiques secondaires peuvent être encombrants et/ou être complexes à concevoir pour obtenir les diagrammes d'émission souhaités. De plus, ils sont couteux et leur rendement est inférieur à 1 ce qui induit une perte de flux global.

Un autre inconvénient des dispositifs optoélectroniques existants est que l'utilisation de systèmes optiques secondaires rend plus complexe le procédé de fabrication du dispositif optoélectronique.

Documents CN 203 038 972 U, US 2007/195524 A1, EP 2 337 099 A2 et EP 1 847 759 A2 divulguent différentes dispositifs optoélectroniques comprenant un support ayant au moins une portion concave ou convexe.

Document WO 2013/080174 A1 divulgue une diode électroluminescente comprenant un élément semi-conducteur cylindrique, conique ou tronconique.

### Résumé

Ainsi, un objet d'un mode de réalisation est de pallier au moins en partie les inconvénients des dispositifs optoélectroniques à diodes électroluminescentes décrits précédemment et de leurs procédés de fabrication.

Un autre objet d'un mode de réalisation est de contrôler le diagramme d'émission d'un dispositif optoélectronique à diodes électroluminescentes sans utiliser de système optique secondaire.

Un autre objet d'un mode de réalisation est de réduire l'encombrement du dispositif optoélectronique.

Un autre objet d'un mode de réalisation est que les dispositifs optoélectroniques à diodes électroluminescentes puissent être fabriqués à une échelle industrielle et à bas coût.

Ainsi, un mode de réalisation prévoit un dispositif optoélectronique comprenant un support comprenant une face ayant au moins une portion concave ou convexe, l'amplitude de la flèche de ladite portion étant supérieure à 1/20^{ème} de la corde de ladite portion et des diodes électroluminescentes reposant sur ladite portion, chaque diode électroluminescente comprenant un élément semiconducteur cylindrique, conique ou tronconique, au contact de ladite portion, l'amplitude de la flèche de la surface de contact entre chaque élément semiconducteur et ladite portion étant inférieure ou égale à 0,5 µm.

Selon un mode de réalisation de la présente invention, le rayon de courbure de ladite portion est supérieur à la moitié de la corde de ladite portion.

Selon un mode de réalisation de la présente invention, le rapport entre la surface de contact de chaque élément semiconducteur et la surface de ladite portion est inférieur à 0,7.

Selon un mode de réalisation de la présente invention, le dispositif comprend au moins 4 diodes électroluminescentes reposant sur ladite portion.

Selon un mode de réalisation de la présente invention, chaque diode électroluminescente comprend une région active adaptée à émettre un rayonnement lumineux, la région active recouvrant au moins partiellement l'élément semiconducteur et n'étant pas au contact de ladite portion.

Selon un mode de réalisation de la présente invention, chaque élément semiconducteur est majoritairement en un composé III-V.

Selon un mode de réalisation de la présente invention, chaque élément semiconducteur comprend majoritairement du nitrure de gallium.

Selon un mode de réalisation de la présente invention, le support comprend une couche d'un matériau métallique, isolant ou semiconducteur ayant une épaisseur supérieure à 100 nm, la surface externe de ladite couche formant ladite portion.

Selon un mode de réalisation de la présente invention, ladite couche est en silicium.

Selon un mode de réalisation de la présente invention, le diamètre moyen de chaque élément semiconducteur est compris entre 5 nm et 2,5 µm.

Un mode de réalisation prévoit également un procédé de fabrication d'un dispositif optoélectronique comprenant les étapes suivantes :
(1) former sur un substrat des diodes électroluminescentes, chaque diode électroluminescente comprenant un élément semiconducteur cylindrique, conique ou tronconique, au contact du substrat ;
(2) amincir le substrat au moins au niveau des diodes électroluminescentes ; et
(3) déformer le substrat pour former au moins une portion concave ou convexe sur laquelle reposent les diodes électroluminescentes, l'amplitude de la flèche de ladite portion étant supérieure à 1/20^{ème} de la corde de ladite portion, l'amplitude de la flèche de la surface de contact entre chaque élément semiconducteur et ladite portion étant inférieure ou égale à 0,5 µm.

Selon un mode de réalisation de la présente invention, à l'étape (3), le substrat est pris en sandwich entre des première et deuxième pièces, au moins l'une des première ou deuxième pièces comprenant une protrusion ou une empreinte dont la forme est complémentaire de ladite portion.

Selon un mode de réalisation de la présente invention, ladite protrusion comprend un matériau déformable.

Selon un mode de réalisation de la présente invention, l'étape (2) comprend la gravure d'une ouverture dans le substrat du côté opposé aux diodes électroluminescentes.

Selon un mode de réalisation de la présente invention, l'étape (2) comprend la fixation d'une poignée du côté des diodes électroluminescentes et l'amincissement de la totalité du substrat.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre des paramètres utilisés dans la présente demande ;
les figures 2 à 4 sont des vues en coupe, partielles et schématiques, de modes de réalisation d'un dispositif optoélectronique ;
les figures 5 et 6 sont des vues en coupe, partielles et schématiques, de modes de réalisation des diodes électroluminescentes du dispositif optoélectronique de la figure 2 ou 3 ;
la figure 7 représente des diagrammes d'émission d'un dispositif optoélectronique connu et des dispositifs optoélectroniques représentés sur les figures 2 et 4 ;
la figure 8 représente des courbes d'évolution du rayon de courbure d'une couche en fonction de la déformation relative maximale de la couche pour plusieurs épaisseurs de couche ;
la figure 9 représente des courbes d'évolution de la flèche d'une couche en fonction du rayon de courbure de la couche pour plusieurs longueurs de couche ;
les figures 10A à 10F sont des vues en coupe, partielles et schématiques, de structures obtenues à des étapes successives d'un mode de réalisation d'un procédé de fabrication du dispositif optoélectronique représenté en figure 2 ; et
les figures 11A à 11E sont des vues en coupe, partielles et schématiques, de structures obtenues à des étapes successives d'un mode de réalisation d'un procédé de fabrication du dispositif optoélectronique représenté en figure 4.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de polarisation des diodes électroluminescentes d'un dispositif optoélectronique sont bien connus et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

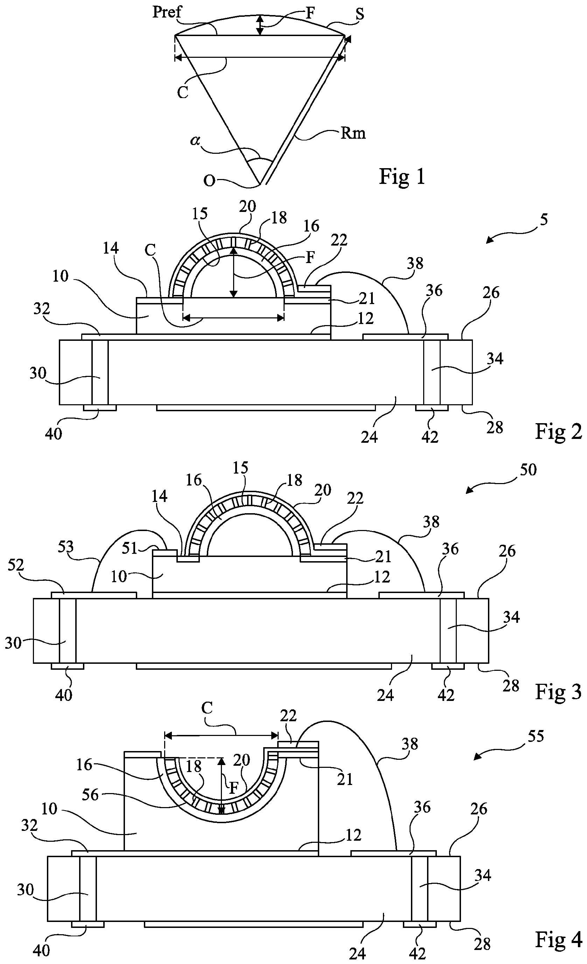

La figure 1 est une coupe schématique d'une surface S. Dans la suite de la description, on appelle flèche F la distance maximale entre la surface S et un plan de référence Pref. En figure 1, le bord de la surface S repose sur le plan de référence Pref. A titre de variante, le plan de référence Pref peut être un plan tangent à la surface S. On appelle rayon de courbure moyen Rm de la surface S le rayon de courbure égal à la moyenne du rayon de courbure de la surface S. Dans le cas où la surface S correspond à une calotte sphérique, le rayon de courbure de la surface S est constant et égal au rayon de courbure moyen Rm. On appelle O le centre de courbure moyen associé à une surface ayant le rayon de courbure moyen Rm et la flèche F et on appelle angle au centre α l'angle dans lequel est inscrite la surface S vue depuis le centre de courbure moyen O. Dans le cas où le bord de la surface S repose sur le plan de référence Pref, on appelle corde C de la surface S le diamètre du disque ayant la même aire que la surface plane délimitée par la courbe de contact de la surface S sur le plan de référence Pref, ce qui correspond au diamètre moyen de la courbe de contact de la surface S sur le plan de référence Pref, autrement dit le diamètre moyen de la bordure de la surface S.

La figure 2 est une vue en coupe, partielle et schématique, d'un mode de réalisation d'un dispositif optoélectronique 5 à diodes électroluminescentes comprenant :
un support 10 conducteur comprenant une face inférieure 12 plane et une face supérieure 14 comprenant une portion bombée 15, également appelée portion convexe par la suite, correspondant à la surface externe d'une couche conductrice 16 ;
des diodes électroluminescentes 18 réparties sur la couche 16 ;
une électrode 20, au moins partiellement transparente, au contact de chaque diode électroluminescente 18 et se prolongeant sur la face 14, une portion isolante 21 étant interposée entre l'électrode 20 et le support 10 ;
un plot conducteur 22 au contact de l'électrode 20 ;
une base 24 comprenant une face supérieure 26 plane sur laquelle est fixé le support 10 et une face inférieure 28 plane opposée à la face supérieure 26 ;
un via 30 traversant la base 24 et connecté à la face arrière 12 du support 10, par exemple par une région conductrice 32 s'étendant sur la face 26 et entre le support 10 et la base 24, le via 30 étant en un matériau conducteur électrique et étant isolé de la base 24 ;
un via 34 traversant la base 24 et connecté au plot 22 du support 10, par exemple par une région conductrice 36 et un fil conducteur 38, le via 34 étant en un matériau conducteur électrique et étant isolé de la base 24 ;
un plot de contact 40 relié au via 30 ; et
un plot de contact 42 relié au via 34.

Dans le mode de réalisation représenté en figure 2, la polarisation des diodes électroluminescentes 18 est réalisée par l'application d'une tension entre l'électrode 20 et la face inférieure 12 du support 10.

La figure 3 est une vue en coupe, partielle et schématique, d'un autre mode de réalisation d'un dispositif optoélectronique 50 comprenant un plot conducteur 51 sur la face 14 et une région conductrice 52 sur la face 26 au contact du via 30 et reliée au plot conducteur 51 par un fil conducteur 53. Dans le mode de réalisation représenté en figure 3, la polarisation des diodes électroluminescentes 18 est réalisée par l'application d'une tension entre les plots de contact 22 et 51, ce qui se traduit, comme pour le dispositif optoélectronique 5 représenté sur la figure 2, par une différence de potentiel entre l'électrode 20 et le support 10 conducteur, plus précisément la surface externe de la couche 16 du support 10.

Dans les figures 2 et 3, le contact supérieur est fait par l'électrode transparente 20 via le plot 22, la portion isolante 21 assurant l'isolation avec le substrat 10 et la couche 16. Dans la figure 2, le contact inférieur est fait à travers la couche 16 via le substrat 10 connecté électriquement au plot 32 de la base 24. Dans la figure 3, le substrat 10 peut être isolant électriquement et le contact est toujours fait à travers la couche 16 mais avec une reprise de contact en face avant sur le plot 21.

A titre de variante, la couche 16 est non conductrice. Dans ce cas, des vias conducteurs traversant la couche 16 peuvent être prévus pour relier électriquement les diodes 18 et le support 10.

La figure 4 est une vue en coupe, partielle et schématique, d'un autre mode de réalisation d'un dispositif optoélectronique 55 à diodes électroluminescentes. Le dispositif optoélectronique 55 comprend l'ensemble des éléments du dispositif 5 représenté en figure 2 à la différence que la portion bombée 15 est remplacée par une portion en creux 56, également appelée portion concave par la suite.

La variante représentée en figure 3 peut également être mise en oeuvre avec le mode de réalisation représenté en figure 4.

L'amplitude de la flèche de la portion convexe 15 ou la portion concave 56 doit être suffisante pour permettre une modification sensible du diagramme d'émission. Typiquement la flèche doit être supérieure à 1/20^{ème} de la corde C de la portion convexe 15 ou concave 56. Par exemple, pour une portion convexe 15 ou concave 56 dont la corde C est égale à 1 mm, la flèche F est d'au moins 50 µm et pour une portion convexe 15 ou concave 56 dont la corde C est égale à 250 µm, la flèche F est d'au moins 12,5 µm. De préférence, la flèche F est égale à un quart de la corde C de la portion convexe 15 ou concave 56. Pour obtenir une forme hémisphérique concave ou convexe, la flèche F est égale à la moitié de la corde C de la portion convexe 15 ou concave 56. La flèche est mesurée, par exemple, par rapport à un plan contenant l'ensemble des points de la bordure de la portion convexe 15 ou de la portion concave 56.

Le rayon de courbure de la portion convexe 15 ou de la portion concave 56 est compris entre 0,5 et 3 mm pour une portion convexe 15 ou concave 56 ayant une corde de 1 mm et une épaisseur de diode élémentaire de l'ordre de 6 µm et un rayon de courbure compris entre 125 et 750 µm pour une portion convexe 15 ou concave 56 ayant une corde de 250 µm. Le rayon de courbure de la portion convexe 15 ou de la portion concave 56 peut ne pas être constant.

Dans un plan de coupe transversal, en considérant le centre de courbure moyen de la portion convexe 15 ou de la portion concave 56, l'angle dans lequel est inscrite la portion convexe 15 ou de la portion concave 56 est supérieur à 23 degrés, de préférence supérieur à 106 degrés.

Dans un plan de coupe transversal contenant la flèche de la portion convexe 15 ou la portion concave 56, la longueur de l'arc formé par la portion convexe 15 ou la portion concave 56 est supérieure à 1,007 mm pour une portion convexe 15 ou une portion concave 56 ayant une corde de 1 mm et 252 µm pour une portion convexe 15 ou une portion concave 56 ayant une corde de 250 µm (cas où la flèche est égale à 1/20^{ème} de la corde), de préférence supérieure à 1,16 mm pour une portion convexe 15 ou une portion concave 56 ayant une corde de 1 mm et 290 µm pour une portion convexe 15 ou une portion concave 56 ayant une corde de 250 µm (cas où la flèche est égale à 1/4 de la corde).

Le dispositif optoélectronique 5 peut comprendre de quelques diodes électroluminescentes 18 à plusieurs milliers de diodes électroluminescentes 18, typiquement de 10000 à 100000 diodes par mm².

La forme de la portion convexe 15 ou de la portion concave 56 est choisie en fonction du diagramme d'émission recherché du dispositif optoélectronique. Selon un mode de réalisation, la portion convexe 15 ou la portion concave 56 correspond à un hémisphère ou à une calotte sphérique. Selon un autre mode de réalisation, la portion convexe 15 ou la portion concave 56 correspond à un demi-cylindre ou à un secteur d'un cylindre.

Dans un mode de réalisation, les diodes électroluminescentes sont formées à partir d'éléments tridimensionnels, par exemple des éléments cylindriques, coniques ou tronconiques, notamment des éléments filaires, en particulier des microfils ou des nanofils. Ces éléments tridimensionnels reposent sur la couche 16, au niveau de la portion bombée 15 ou de la portion concave 56 de la face 14.

La région active de chaque diode électroluminescente qui est la région depuis laquelle est émise la majorité du rayonnement électromagnétique fourni par la diode électroluminescente est formée sur l'élément tridimensionnel et n'est pas en contact avec la couche 16.

L'amplitude de la flèche de la surface de contact entre l'élément tridimensionnel et la couche 16 est inférieure à 0,5 µm, de préférence inférieure à 0,1 µm, la valeur de 0,5 µm correspond à une portion convexe 15 ou concave 56 ayant une corde de 100 µm et la valeur de 0,1 µm correspond à une portion convexe 15 ou concave 56 ayant une corde de 20 µm. Grâce à cette condition, les propriétés optoélectroniques, en particulier la longueur d'onde d'émission, de l'élément tridimensionnel (donc de la diode élémentaire) ne sont pas modifiées.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 800 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

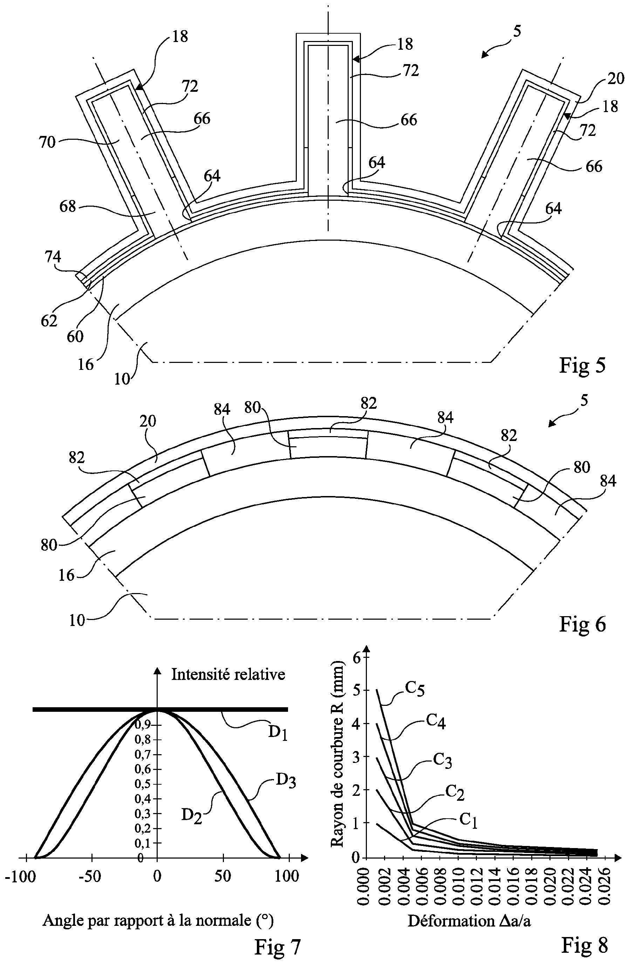

La figure 5 est une vue en coupe plus détaillée du dispositif optoélectronique 5 et illustre un mode de réalisation des diodes électroluminescentes 18, trois diodes électroluminescentes étant représentées.

Dans ce mode de réalisation, le dispositif optoélectronique 5 comprend du bas vers le haut :
une couche de germination 60 favorisant la croissance de fils et disposée sur la couche 16 ;
une couche isolante 62 recouvrant la couche de germination 60 et comprenant des ouvertures 64, exposant des parties de la couche de germination 60 ;
des fils 66 en contact avec la couche de germination 60 au travers de l'une des ouvertures 64, chaque fil 20 comprenant une portion inférieure 68, en contact avec la couche de germination 60 et une portion supérieure 70, prolongeant la portion inférieure 68 ;
une coque 72 comprenant un empilement de couches semiconductrices recouvrant chaque portion supérieure 70 ;
une couche isolante 74 s'étendant sur la couche isolante 62 sur les flancs latéraux de la portion inférieure 68 de chaque fil 66 et, éventuellement, sur une partie de la coque 72 ; et
une couche formant l'électrode 20 recouvrant chaque coque 72 et s'étendant, en outre, sur la couche isolante 74.

Le dispositif optoélectronique 5 peut, en outre, comprendre une couche conductrice recouvrant au moins partiellement la couche d'électrode 20 entre les fils 66 mais ne s'étendant pas sur les fils 66 et formant le plot 22.

La figure 6 est une vue en coupe plus détaillée du dispositif optoélectronique 5 et illustre un autre mode de réalisation des diodes électroluminescentes 18, trois diodes électroluminescentes étant représentées.

Dans ce mode de réalisation, le dispositif optoélectronique 5 comprend du bas vers le haut :
des pieds cylindriques 80 en contact avec la couche de germination 60 ;
une portion active 82 au sommet de chaque pied 80 ;
des portions isolantes 84 s'étendant sur la couche 16 entre les pieds 80 ; et
une couche formant l'électrode 20 recouvrant chaque portion active 82 et s'étendant, en outre, sur les portions isolantes 84.

Le dispositif optoélectronique 5 peut, en outre, comprendre une couche d'encapsulation recouvrant l'ensemble de la structure et notamment l'électrode 20. Le dispositif optoélectronique 5 peut, en outre, comprendre une couche de luminophores, non représentée, prévue sur la couche d'encapsulation ou confondue avec celle-ci. L'amplitude de la flèche de la couche 16 doit être suffisante pour permettre une modification sensible du diagramme d'émission. Typiquement la flèche doit être supérieure à 1/20^{ème} de la corde de la portion convexe 15 ou concave 56. Par exemple, pour une portion convexe 15 ou concave 56 dont la corde est de 1 mm, la flèche sera d'au moins 50 µm et pour une portion convexe 15 ou concave 56 dont la corde est de 250 µm, la flèche est d'au moins 12,5 µm et de préférence, égale à 1/4 de la corde de la portion convexe 15 ou concave 56. Pour obtenir une forme hémisphérique concave ou convexe, la flèche sera égale à la moitié de la corde de la portion convexe 15 ou concave 56. La flèche est mesurée, par exemple, par rapport à un plan contenant le bord de la portion convexe 15 ou de la portion concave 56. La couche 16 est de préférence en un matériau pouvant être déformé de façon élastique sans rupture avec une épaisseur comprise entre 0,1 et 50 µm. L'épaisseur maximale est définie par la limite à la rupture et est égale, dans le cas du silicium, à environ 50 µm.

La couche 16 est de préférence en un matériau semiconducteur, par exemple en silicium, en germanium, en carbure de silicium, en un composé III-V, tel que du GaN ou du GaAs, ou un substrat en ZnO. De préférence, la couche 16 est en silicium monocristallin. De préférence, la couche 16 est en un matériau semiconducteur compatible avec les procédés de fabrication mis en oeuvre en microélectronique. A titre de variante, la couche 16 peut être une couche métallique (par exemple en tungstène ou en molybdène).

A titre de variante, la couche 16 peut être formée en un matériau réfractaire (ayant une température de fusion typiquement supérieure ou égale à 1000°C) présentant une limite élastique compatible avec la déformation attendue.

La couche 16 peut être non conductrice électriquement, auquel cas on prévoit une polarisation des diodes 18 via une couche intermédiaire conductrice disposée entre la couche 16 et les diodes 18.

La couche 16 peut être formée en un matériau à base de silice. Des exemples de matériaux à base de silice sont le quartz, la silice fondue ou un verre à base de silice.

La couche de germination 60 est réalisée en un matériau favorisant la croissance des fils 66. Selon un autre mode de réalisation, la couche de germination 60 est remplacée par des plots de germination, chaque fil 66 reposant sur l'un des plots de germination. A titre d'exemple, le matériau composant la couche de germination 60 peut être un nitrure, un carbure ou un borure d'un métal de transition de la colonne IV, V ou VI du tableau périodique des éléments ou une combinaison de ces composés. A titre d'exemple, la couche de germination 60 peut être en nitrure d'aluminium (AIN), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), en nitrure de magnésium sous la forme MgₓN_{y}, où x est environ égal à 3 et y est environ égal à 2, par exemple du nitrure de magnésium selon la forme Mg₃N₂ ou du nitrure de gallium et de magnésium (MgGaN), en tungstène (W), en nitrure de tungstène (WN) ou en une combinaison de ceux-ci.

Les couches isolantes 62, 74 et les portions isolantes 84 peuvent être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (SiOₓN_{y} où x peut être environ égal à 1/2 et y peut être environ égal à 1, par exemple du Si₂ON₂), en oxyde d'aluminium (Al₂O₃), en oxyde d'hafnium (HfO₂) ou en diamant. A titre d'exemple, l'épaisseur de la couche isolante 62 et de la couche isolante 74 est comprise entre 5 nm et 500 nm, par exemple égale à environ 100 nm.

Les fils 66 et les pieds 80 sont, au moins en partie, formés à partir d'au moins un matériau semiconducteur. Le matériau semiconducteur peut être du silicium, du germanium, du carbure de silicium, un composé III-V, un composé II-VI ou une combinaison d'au moins deux de ces composés.

Les fils 66 et les pieds 80 peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils 66 et les pieds 80 peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI comprennent des éléments du groupe VIA, notamment l'oxygène (O) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Les fils 66 et les pieds 80 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn) .

La section droite des fils 66 et des pieds 80 peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'un pied, il s'agit d'une grandeur associée à la surface de la structure visée dans cette section droite, correspondant, par exemple, au diamètre du disque ayant la même surface que la section droite du fil. De préférence, le diamètre moyen du fil 66 ou du pied 80 est compris entre 5 nm et 2,5 µm, de préférence entre 50 nm et 2,5 µm, plus préférentiellement entre 200 nm et 1 µm, en particulier entre 300 nm et 800 nm.

Les axes de deux fils 66 adjacents ou de deux pieds 80 adjacents peuvent être distants de 0,5 µm à 10 µm et de préférence de 1,5 µm à 4 µm.

La coque 72 ou la région active 82 peuvent comprendre un empilement de plusieurs couches comprenant notamment :
- une couche active recouvrant la portion supérieure du fil 66 ou du pied 80 associé ;
- une couche intermédiaire de type de conductivité opposé au fil ou au pied et recouvrant la couche active ; et
- une couche de liaison recouvrant la couche intermédiaire et recouverte par l'électrode 20.

La couche active est la couche depuis laquelle est émise la majorité du rayonnement fourni par la diode électroluminescente. Selon un exemple, la couche active peut comporter des moyens de confinement, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 5 nm.

La couche intermédiaire, par exemple dopée de type P, peut correspondre à une couche semiconductrice ou à un empilement de couches semiconductrices et permet la formation d'une jonction P-N ou P-I-N, la couche active étant comprise entre la couche intermédiaire de type P et la portion de type N de la jonction P-N ou P-I-N.

La couche de liaison peut correspondre à une couche semiconductrice ou à un empilement de couches semiconductrices et permet la formation d'un contact ohmique entre la couche intermédiaire et l'électrode 20. A titre d'exemple, la couche de liaison peut être dopée fortement du type opposé au fil 66 ou au pied 80.

L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

L'électrode 20 est adaptée à polariser la couche active de la diode électroluminescente et à laisser passer le rayonnement électromagnétique émis par les diodes électroluminescentes. Le matériau formant l'électrode 20 peut être un matériau transparent et conducteur tel que de l'oxyde d'indium-étain (ou ITO, acronyme anglais pour Indium Tin Oxide), de l'oxyde de zinc dopé à l'aluminium ou du graphène. A titre d'exemple, la couche d'électrode 20 a une épaisseur comprise entre 5 nm et 200 nm, de préférence entre 20 nm et 50 nm.

De façon avantageuse, l'allure du diagramme d'émission du dispositif optoélectronique peut être commandée en modifiant le rayon de courbure de la portion convexe ou concave 15, 56 sur laquelle sont formées les diodes électroluminescentes 18. En particulier, le diagramme d'émission peut être rendu plus ou moins isotrope selon la courbure de la portion convexe ou concave 15, 56.

La figure 7 représente des diagrammes d'émission D₁, D₂ et D₃ respectivement du dispositif optoélectronique 5 représenté en figure 2 dont la portion convexe 15 correspond à un hémisphère, du dispositif optoélectronique 55 représenté en figure 4 dont la portion concave 56 correspond à un hémisphère et d'un dispositif optoélectronique pour lequel les diodes électroluminescentes sont formées sur un support plan.

Le diagramme d'émission D₃ a sensiblement la forme d'une cloche, ce qui signifie que l'intensité relative maximale est obtenue selon une direction d'observation perpendiculaire à la face plane sur laquelle sont formées les diodes électroluminescentes et diminue lorsque la direction d'observation est inclinée par rapport à la direction d'intensité relative maximale.

Selon le diagramme d'émission D₁, l'intensité relative est sensiblement la même quelle que soit l'inclinaison de la direction d'observation. Un éclairage homogène est avantageusement obtenu. Selon le diagramme d'émission D₂, l'intensité relative diminue plus rapidement que pour le diagramme d'émission D₃ lorsque la direction d'observation est inclinée par rapport à la direction d'intensité relative maximale. Une meilleure concentration du faisceau de lumière émis par la diode est ainsi obtenue.

Le procédé de fabrication des modes de réalisation du dispositif optoélectronique décrits précédemment comprend successivement la formation des diodes électroluminescentes 18 sur la couche semiconductrice 16 alors que celle-ci est sensiblement plane et la déformation de la couche 16.

Les inventeurs ont dans un premier temps essayé de réaliser une diode électroluminescente sur la totalité de la couche 16. Toutefois, il a été observé une variation de la longueur d'onde du rayonnement émis par la diode électroluminescente lorsque la couche 16 était déformée, cette variation dépendant de la courbure appliquée aux couches actives de la diode électroluminescente.

La figure 8 représente des courbes d'évolution C₁ à C₅ du rayon de courbure d'une couche en fonction de la déformation relative maximale de la couche pour des épaisseurs de couches respectivement de 2 µm, 4 µm, 6 µm, 8 µm et 10 µm.

Les inventeurs ont mis en évidence qu'une variation de la longueur d'onde inférieure à 2 nm était obtenue lorsque la déformation relative maximale de la région active de la diode électroluminescente était inférieure à 0,2 %. Pour une épaisseur totale de diode de 6 µm (couche de germination 60, fils 66 et coque 78 pour la diode représentée en figure 5 et zones 80 et 82 pour la diode représentée en figure 8), cela correspond à un rayon de courbure minimum de 2,5 mm.

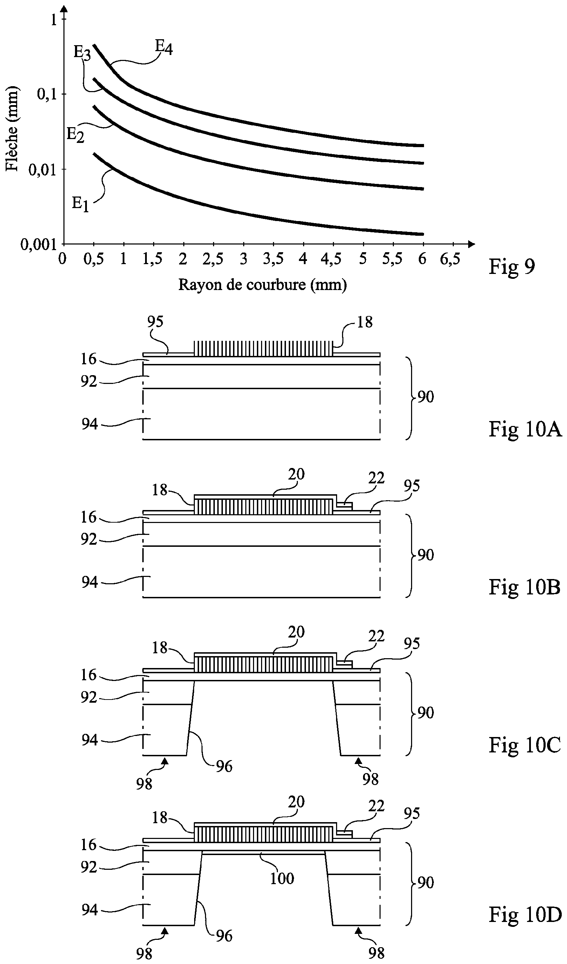

La figure 9 représente des courbes d'évolution E₁ à E₄ de la flèche, en échelle logarithmique, d'une couche en fonction du rayon de courbure de la couche pour des cordes dans un plan de coupe transversal respectivement de 250 µm, 500 µm, 750 µm et 1 mm. Pour une diode électroluminescente ayant une longueur d'arc de 1,007 mm, un rayon de courbure minimum de 2,5 mm correspond à une flèche maximale de 50 µm. Cette flèche maximale est faible de sorte qu'il n'est pas possible de modifier de façon importante le diagramme d'émission du dispositif optoélectronique par rapport à une structure plane.

Les inventeurs ont mis en évidence qu'une couche 16 ayant une amplitude de flèche supérieure à 100 µm pouvait être obtenue en formant plusieurs diodes électroluminescentes distinctes sur la couche 16. En effet, l'amplitude de flèche de la région active de chaque diode élémentaire est alors inférieure à l'amplitude de flèche de la couche 16. Ceci permet à la fois de commander le diagramme d'émission obtenu par la courbure de la couche 16 tout en maintenant la variation de la longueur d'onde du rayonnement émis à moins de 2 nm par rapport à une structure plane.

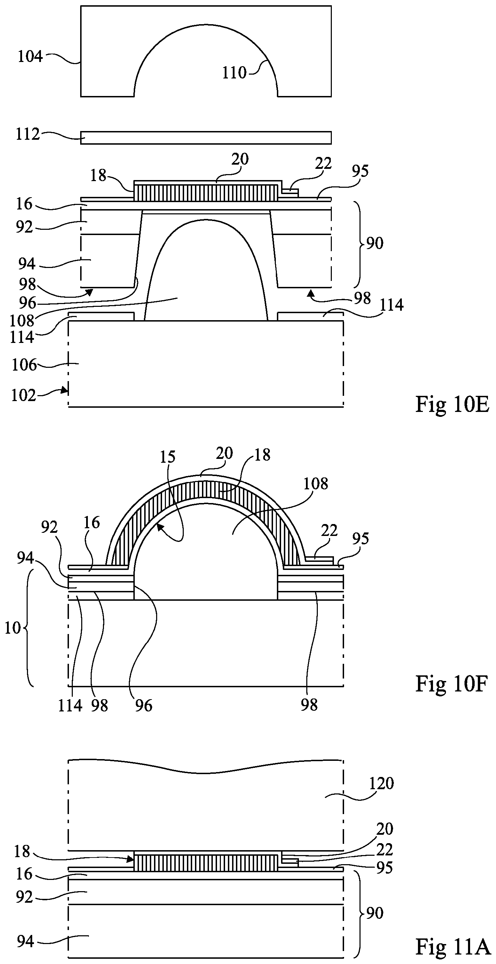

Les figures 10A à 10F illustrent un mode de réalisation d'un procédé de fabrication du dispositif optoélectronique 5. Ce mode de réalisation comprend les étapes suivantes :
(1) Formation des diodes électroluminescentes 18 sur un substrat 90 (figure 10A). Dans le présent mode de réalisation, le substrat 90 comprend la couche 16 qui recouvre une couche 92 d'un matériau isolant, par exemple du dioxyde de silicium, elle-même recouvrant une plaque 94 d'un matériau semiconducteur, par exemple du silicium. L'épaisseur de la couche diélectrique 92 peut être comprise entre 50 nm et 10 µm. L'épaisseur de la plaque 94 peut être comprise entre 525 µm et 2 mm. Plusieurs dispositifs optoélectroniques peuvent être réalisés sur le substrat 90. Les diodes électroluminescentes 18 sont alors rassemblées en groupes de diodes pour chaque dispositif optoélectronique. Une couche isolante 95 recouvre la couche 16 autour des diodes électroluminescentes 18.
   Dans le cas où les diodes électroluminescentes 18 ont la structure représentée en figure 5, elles peuvent être réalisées en faisant croître les fils 66 puis en formant les coques 72 qui recouvrent les flancs latéraux et le sommet des fils 66. Dans le cas où les diodes électroluminescentes 18 ont la structure représentée en figure 6, elles peuvent être réalisées en formant, sur la totalité de la couche 16, un empilement de couches ayant la même structure que la diode électroluminescente souhaitée, en gravant cet empilement, par exemple par gravure au plasma, gravure chimique ou par découpe laser, pour délimiter chaque diode électroluminescente 18 et en remplissant les espaces entre les diodes électroluminescentes par les portions isolantes 84.
(2) Formation, pour chaque dispositif optoélectronique, de l'électrode 20 et du plot conducteur 22 (figure 10B), par exemple par dépôt conforme.
(3) Gravure, pour chaque dispositif optoélectronique, d'une ouverture 96 dans la plaque 94 et dans la couche diélectrique 92 pour exposer une portion de la couche 16 (figure 10C) sensiblement opposée au groupe de diodes électroluminescentes 18 du dispositif optoélectronique. L'ouverture 96 est délimitée par des portions 98 de la couche diélectrique 92 et de la plaque 94. La formation de l'ouverture 96 peut comprendre des première et deuxième étapes. La première étape comprend la gravure de la plaque 94, la couche diélectrique 92 pouvant alors jouer le rôle de couche d'arrêt de gravure lors de la gravure de la plaque 94. La deuxième étape comprend la gravure de la couche diélectrique 92, la couche semiconductrice 16 pouvant alors jouer le rôle de couche d'arrêt de gravure lors de la gravure de la couche diélectrique 92. En vue de dessous, l'ouverture 96 peut occuper une surface de l'ordre de 1 mm². La distance entre les flancs latéraux de deux ouvertures 96 adjacentes peut être de l'ordre de 50 µm.
(4) Formation, pour chaque dispositif optoélectronique, d'une région conductrice 100 sur la face de la couche 16 exposée par l'ouverture 96 (figure 10D). A titre d'exemple, la région conductrice 100 est une région métallique. La région conductrice 100 peut comprendre un empilement de couches. A titre d'exemple, la région conductrice 100 peut comprendre une couche d'un siliciure au contact de la couche 16, par exemple du siliciure de nickel (SiNi) ou du siliciure de titane (TiSi₂), et une couche métallique.
(5) Déformation de la couche 16 pour obtenir la portion convexe 15 (figures 10E). La figure 10E est une vue éclatée du système de mise en forme de la couche 16. Selon un mode de réalisation, il est utilisé un interposeur 102 et un contre-moule 104. L'interposeur 102 peut comprendre une plaque 106 sur laquelle est formé un bloc 108 d'un matériau déformable pour chaque dispositif optoélectronique. De préférence, le bloc 108 et la plaque 106 sont chacun en un matériau conducteur électriquement. A titre d'exemple, chaque bloc 108 est en un matériau de brasure. Le contre-moule 104 comprend, pour chaque dispositif optoélectronique, une empreinte 110 ayant une forme complémentaire de la surface externe souhaitée du dispositif optoélectronique.

La déformation de la couche 16 est obtenue par la mise en sandwich du substrat 90 entre l'interposeur 102 et le contre-moule 104, le bloc de matériau déformable venant remplir l'ouverture 96. Un film 112 d'un élastomère peut être interposé entre le contre-moule 104 et les diodes électroluminescentes lors de l'étape d'assemblage pour augmenter l'homogénéité des contraintes appliquées aux diodes électroluminescentes 18. Une couche de colle conductrice 114 peut être prévue entre l'interposeur 106 et le substrat 90.

Le volume du bloc 108 est déterminé pour que, lorsque le substrat 90 est plaqué contre la plaque 102, l'ouverture 96 soit complètement remplie du matériau constituant le bloc 108 et la couche 16 soit déformée selon la forme de l'empreinte 110. De préférence, l'opération d'assemblage est réalisée à une température strictement inférieure à la température de fusion du matériau composant les blocs 108 et à une température supérieure à deux tiers de la température de fusion du matériau composant les blocs 108 exprimée en Kelvins. A titre d'exemple, lorsque les blocs 108 sont réalisés en un alliage d'étain, d'argent et de cuivre du type SAC305, la température d'assemblage peut être supérieure à 55°C.

Avant et après déformation, la corde de la portion déformée est constante car les extrémités de cette portion sont bloquées lors de la déformation.

Selon un autre mode de réalisation, le contre-moule 110 est mis en appui contre le substrat 10 seulement aux emplacements où les diodes électroluminescentes 18 ne sont pas présentes. Ceci permet avantageusement de ne pas appliquer de pression sur les diodes électroluminescentes 18.

Selon un autre mode de réalisation, l'interposeur 102 peut correspondre à une structure monobloc et être réalisé par usinage ou par emboutissage.
(6) Découpe de l'interposeur 102 et du substrat 90 pour séparer les dispositifs optoélectroniques 5 (figure 10F). Le support 10 représenté aux figures 2 et 3 correspond à l'ensemble comprenant la portion découpée de l'interposeur 102, la portion découpée du substrat 90 et le bloc 108.

Le procédé comprend des étapes ultérieures de fixation de l'interposeur 102 sur la base 24.

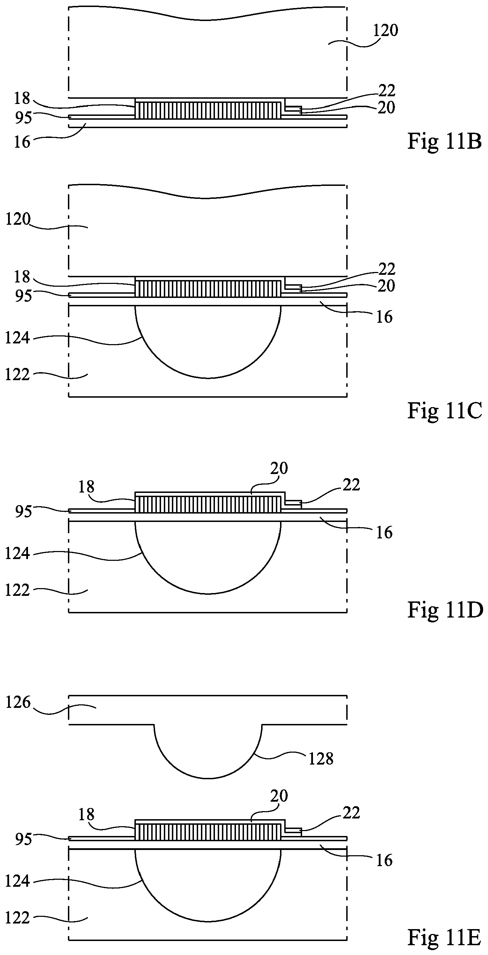

Les figures 11A à 11E illustrent un mode de réalisation d'un procédé de fabrication du dispositif optoélectronique 55. Ce mode de réalisation comprend les étapes (1) et (2) décrites précédemment. Il comprend, en outre, les étapes suivantes :
(3)' Fixation d'une poignée 120 à l'électrode 20 (figure 11A).
(4)' Gravure de la plaque 94 et de la couche diélectrique 92 pour exposer la couche 16 (figure 11B). La poignée 120 permet de façon avantageuse de manipuler la couche 16.
(5)' Application de la couche 16 sur un interposeur 122 ayant, pour chaque dispositif optoélectronique, une empreinte 124 dont la forme est le complémentaire de la forme souhaitée pour la couche 16 (figure 11C). Une couche de colle peut être prévue entre l'interposeur 122 et la couche 16.
(6)' Retrait de la poignée 120 (figure 11D).
(7)' Déformation de la couche 16 (figures 11E). Selon un mode de réalisation, il est utilisé un contre-moule 126. Le contre-moule 126 comprend, pour chaque dispositif optoélectronique, une protrusion 128 ayant une forme complémentaire de la surface externe souhaitée du dispositif optoélectronique.

La déformation de la couche 16 est obtenue par la mise en sandwich de la couche 16 entre l'interposeur 122 et le contre-moule 126. Un film, non représenté, d'un élastomère peut être interposé entre le contre-moule 126 et l'électrode 20 lors de l'étape d'assemblage pour augmenter l'homogénéité des contraintes appliquées aux diodes électroluminescentes 18.

Avant et après déformation, la corde de la portion déformée est constante car les extrémités de cette portion sont bloquées lors de la déformation. Le procédé continue avec la découpe des dispositifs optoélectroniques 55 et la fixation de l'interposeur 122 sur la base 24.

Des modes de réalisation particuliers de la présente invention ont été décrits. Diverses variantes et modifications apparaîtront à l'homme de l'art. De plus, bien que, dans les modes de réalisation décrits précédemment, chaque fil 66 comprenne une portion passivée, à la base du fil en contact avec la couche de germination 60, cette portion passivée peut ne pas être présente.

## Revendications

1. Dispositif optoélectronique (5 ; 50 ; 55) comprenant :
un support (10) comprenant une face (14) ayant au moins une portion (15 ; 56) concave ou convexe, l'amplitude de la flèche (F) de ladite portion étant supérieure à 1/20^{ème} de la corde (C) de ladite portion ; et
des diodes électroluminescentes (18) reposant sur ladite portion, **caractérisé en ce que** chaque diode électroluminescente comprend un élément semiconducteur (66 ; 80) cylindrique, conique ou tronconique, au contact de ladite portion, l'amplitude de la flèche de la surface de contact entre chaque élément semiconducteur et ladite portion étant inférieure ou égale à 0,5 µm.

2. Dispositif optoélectronique selon la revendication 1, dans lequel le rayon de courbure de ladite portion (15 ; 56) est supérieur à la moitié de la corde (C) de ladite portion.

3. Dispositif optoélectronique selon la revendication 1 ou 2, dans lequel le rapport entre la surface de contact de chaque élément semiconducteur (66 ; 80) et la surface de ladite portion (15 ; 56) est inférieur à 0,7.

4. Dispositif optoélectronique selon l'une quelconque des revendications 1 à 3, comprenant au moins 4 diodes électroluminescentes (18) reposant sur ladite portion (15 ; 56).

5. Dispositif optoélectronique selon l'une quelconque des revendications 1 à 4, dans lequel chaque diode électroluminescente (18) comprend une région active (72 ; 82) adaptée à émettre un rayonnement lumineux, la région active recouvrant au moins partiellement l'élément semiconducteur (66 ; 80) et n'étant pas au contact de ladite portion (15 ; 56).

6. Dispositif optoélectronique selon l'une quelconque des revendications 1 à 5, dans lequel chaque élément semiconducteur (66 ; 80) est majoritairement en un composé III-V.

7. Dispositif optoélectronique selon la revendication 6, dans lequel chaque élément semiconducteur (66 ; 80) comprend majoritairement du nitrure de gallium.

8. Dispositif optoélectronique selon l'une quelconque des revendications 1 à 7, dans lequel le support (10) comprend une couche (16) d'un matériau métallique, isolant ou semiconducteur ayant une épaisseur supérieure à 100 nm, la surface externe de ladite couche formant ladite portion (15 ; 56) .

9. Dispositif optoélectronique selon la revendication 8, dans lequel ladite couche (16) est en silicium.

10. Dispositif optoélectronique selon l'une quelconque des revendications 1 à 9, dans lequel le diamètre moyen de chaque élément semiconducteur (66 ; 80) est compris entre 5 nm et 2,5 µm.

11. Procédé de fabrication d'un dispositif optoélectronique (5 ; 50 ; 55) comprenant les étapes suivantes :
(1) former sur un substrat (90) des diodes électroluminescentes (18), chaque diode électroluminescente comprenant un élément semiconducteur (66 ; 80) cylindrique, conique ou tronconique, au contact du substrat ;
(2) amincir le substrat au moins au niveau des diodes électroluminescentes ; et
(3) déformer le substrat pour former au moins une portion (15 ; 56) concave ou convexe sur laquelle reposent les diodes électroluminescentes, l'amplitude de la flèche de ladite portion étant supérieure à 1/20^{ème} de la corde de ladite portion, l'amplitude de la flèche de la surface de contact entre chaque élément semiconducteur et ladite portion étant inférieure ou égale à 0,5 µm.

12. Procédé selon la revendication 11, dans lequel, à l'étape (3), le substrat (90) est pris en sandwich entre des première et deuxième pièces (102, 104 ; 122, 126), au moins l'une des première ou deuxième pièces comprenant une protrusion (108) ou une empreinte (124) dont la forme est complémentaire de ladite portion (15 ; 56).

13. Procédé selon la revendication 12, dans lequel ladite protrusion (108) comprend un matériau déformable.

14. Procédé selon l'une quelconque des revendications 11 à 13, dans lequel l'étape (2) comprend la gravure d'une ouverture (96) dans le substrat (90) du côté opposé aux diodes électroluminescentes (18).

15. Procédé selon l'une quelconque des revendications 11 à 13, dans lequel l'étape (2) comprend la fixation d'une poignée (120) du côté des diodes électroluminescentes (18) et l'amincissement de la totalité du substrat (90).

## Patentansprüche

1. Eine optoelektronische Vorrichtung (5; 50; 55), die Folgendes aufweist:
einen Träger (10), der eine Oberfläche (14) aufweist, die wenigstens ein konkaves oder konvexes Teil (15; 56) besitzt, wobei die Amplitude der Auslenkung (F) des Teils größer als 1/20^{el} der Bogensehne (C) des Teils ist; und
Licht-emittierende Dioden (18), die an dem Teil liegen, **dadurch gekennzeichnet, dass** jede Licht-emittierende Diode ein zylindrisches, konisches oder sich verjüngendes Halbleiterelement (66; 80) in Kontakt mit dem Teil aufweist, wobei die Amplitude der Auslenkung der Kontaktoberfläche zwischen jedem Halbleiterelement und dem Teil kleiner oder gleich 0,5 µm ist.

2. Optoelektronische Vorrichtung nach Anspruch 1, wobei der Radius der Krümmung des Teils (15; 56) größer als die Hälfte der Bogensehne (C) des Teils ist.

3. Optoelektronische Vorrichtung nach Anspruch 1 oder 2, wobei das Verhältnis von dem Kontaktoberflächenbereich jedes Halbleiterelements (66; 80) zu dem Oberflächenbereich des Teils (15; 56) kleiner als 0,7 ist.

4. Optoelektronische Vorrichtung nach einem der Ansprüche 1 bis 3, die wenigstens 4 Licht-emittierende Dioden (18) aufweist, die an dem Teil (15; 56) liegen.

5. Optoelektronische Vorrichtung nach einem der Ansprüche 1 bis 4, wobei jede Licht-emittierende Diode (18) eine aktive Region (72; 82) aufweist, die geeignet ist, eine Lichtstrahlung zu emittieren, wobei die aktive Region wenigstens teilweise das Halbleiterelement (66; 80) abdeckt und nicht in Kontakt mit dem Teil (15; 56) ist.

6. Optoelektronische Vorrichtung nach einem der Ansprüche 1 bis 5, wobei jedes Halbleiterelement (66; 80) hauptsächlich aus einem III-V-Verbund ist.

7. Optoelektronische Vorrichtung nach Anspruch 6, wobei jedes Halbleiterelement (66; 80) hauptsächlich Galliumnitrid aufweist.

8. Optoelektronische Vorrichtung nach einem der Ansprüche 1 bis 7, wobei der Träger (10) eine Schicht (16) aus einem metallischen, isolierenden oder Halbleiter-Material mit einer Dicke größer als 100 nm aufweist, wobei die Außenfläche der Schicht den Teil (15; 56) bildet.

9. Optoelektronische Vorrichtung nach Anspruch 8, wobei die Schicht (16) aus Silizium ist.

10. Optoelektronische Vorrichtung nach einem der Ansprüche 1 bis 9, wobei der Mitteldurchmesser jedes Halbleiterelements (66; 80) in dem Bereich von 5 nm bis 2,5 µm ist.

11. Verfahren zur Herstellung einer optoelektronischen Vorrichtung (5; 50; 55), das folgende Schritte aufweist:
(1) Ausbilden an einem Substrat (90) Licht-emittierende Dioden (18), wobei jede Licht-emittierende Diode ein zylindrisches, konisches oder sich verjüngendes Halbleiterelement (66; 80) in Kontakt mit dem Substrat aufweist;
(2) Dünnermachen des Substrats auf wenigstens das Niveau der Licht-emittierenden Dioden; und
(3) Verformen des Substrats zum Bilden wenigstens eines konkaven oder konvexen Teils (15; 56), der Licht-emittierende Dioden daran besitzt, wobei die Amplitude der Auslenkung des Teils größer als 1/20el der Bogensehne des Teils ist, wobei die Amplitude der Auslenkung der Kontaktoberfläche zwischen jedem Halbleiterelement und dem Teil kleiner oder gleich 0,5 µm ist.

12. Verfahren nach Anspruch 11, wobei in Schritt (3) das Substrat (90) zwischen ersten und zweiten Teilen (102; 104; 122; 126) dazwischen aufgenommen wird, wobei wenigstens einer der ersten oder zweiten Teilen einen Vorsprung (108) oder eine Aushöhlung (124) aufweist, die eine dem Teil (15; 56) komplementäre Form besitzen.

13. Verfahren nach Anspruch 12, wobei der Vorsprung (108) ein verformbares Material aufweist.

14. Verfahren nach einem der Ansprüche 11 bis 13, wobei Schritt (2) Ätzen einer Öffnung (96) in das Substrat (90) an der Seite gegenüber der Licht-emittierenden Dioden (18) aufweist.

15. Verfahren nach einem der Ansprüche 11 bis 13, wobei Schritt (2) Befestigen eines Griffs (120) an der Seite der Licht-emittierenden Dioden (18) und Dünnermachen des gesamten Substrats (90) aufweist.

## Claims

1. An optoelectronic device (5; 50; 55) comprising:
a support (10) comprising a surface (14) having at least one concave or convex portion (15; 56), the amplitude of the deflection (F) of said portion being greater than 1/20^{th} of the chord (C) of said portion; and
light-emitting diodes (18) resting on said portion, **characterized in that** each light-emitting diode comprises a cylindrical, conical or tapered semiconductor element (66; 80) in contact with said portion, the amplitude of the deflection of the contact surface between each semiconductor element and said portion being smaller than or equal to 0.5 µm.

2. The optoelectronic device of claim 1, wherein the radius of curvature of said portion (15; 56) is greater than half the chord (C) of said portion.

3. The optoelectronic device of claim 1 or 2, wherein the ratio of the contact surface area of each semiconductor element (66; 80) to the surface area of said portion (15; 56) is smaller than 0.7.

4. The optoelectronic device of any of claims 1 to 3, comprising at least 4 light-emitting diodes (18) resting on said portion (15; 56).

5. The optoelectronic device of any of claims 1 to 4, wherein each light-emitting diode (18) comprises an active region (72; 82) capable of emitting a light radiation, where the active region at least partially covers the semiconductor element (66; 80) and is not in contact with said portion (15; 56).

6. The optoelectronic device of any of claims 1 to 5, wherein each semiconductor element (66; 80) is mainly made of a III-V compound.

7. The optoelectronic device of claim 6, wherein each semiconductor element (66; 80) mainly comprises gallium nitride.

8. The optoelectronic device of any of claims 1 to 7, wherein the support (10) comprises a layer (16) of a metallic, insulating, or semiconductor material having a thickness greater than 100 nm, the external surface of said layer forming said portion (15; 56).

9. The optoelectronic device of claim 8, wherein said layer (16) is made of silicon.

10. The optoelectronic device of any of claims 1 to 9, wherein the mean diameter of each semiconductor element (66; 80) is in the range from 5 nm to 2.5 µm.

11. A method of manufacturing an optoelectronic device (5; 50; 55), comprising the steps of:
(1) forming on a substrate (90) light-emitting diodes (18), each light-emitting diode comprising a cylindrical, conical, or tapered semiconductor element (66; 80), in contact with the substrate;
(2) thinning the substrate at least at the level of the light-emitting diodes; and
(3) deforming the substrate to form at least a concave or convex portion (15; 56) having light-emitting diodes resting thereon, the amplitude of the deflection of said portion being greater than 1/20^{th} of the chord of said portion, the amplitude of the deflection of the contact surface between each semiconductor element and said portion being smaller than or equal to 0.5 µm.

12. The method of claim 11, wherein, at step (3), the substrate (90) is sandwiched between first and second parts (102, 104; 122, 126), at least one of the first or second parts comprising a protrusion (108) or a cavity (124) having a shape complementary to said portion (15; 56).

13. The method of claim 12, wherein said protrusion (108) comprises a deformable material.

14. The method of any of claims 11 to 13, wherein step (2) comprises etching an opening (96) into the substrate (90) on the side opposite to the light-emitting diodes (18).

15. The method of any of claims 11 to 13, wherein step (2) comprises fastening a handle (120) on the side of the light-emitting diodes (18) and thinning the entire substrate (90).
